# EUROPEAN PATENT APPLICATION

(11) **EP 4 152 559 A1**
(43) Date of publication of application: **22.03.2023**
(21) Application number: 22196179.0
(22) Date of filing: 16.09.2022
(51) Int. Cl.: H02J 7/00, H02J 9/06, H01M 10/42

(54) **ENERGY STORAGE SYSTEM, UNINTERRUPTIBLE POWER SYSTEM, AND BATTERY EQUALIZATION METHOD**

(30) Priority: 17.09.2021 CN 202111095500
(71) Applicant: Huawei Digital Power Technologies Co., Ltd., Shenzhen, 518043 (CN)
(72) Inventor: ZHANG, Chuntao, Shenzhen, 518129 (CN)
(74) Representative: Gill Jennings & Every LLP

(57) **Abstract**

This application discloses an energy storage system, an uninterruptible power system, and a battery equalization method. The energy storage system includes a plurality of bidirectional power converters (P1, P2, PN) and a plurality of windings (L1, L2, LN). The plurality of windings share a magnetic core. A controller (100) transfers energy of a target battery to the magnetic core by using a target bidirectional power converter and a target winding at a same time. A voltage of the target battery is greater than those of some or all batteries other than the target battery. As the battery is charged and discharged, the voltage of the battery changes, and the controller only needs to find a new target battery to continue discharging until voltages of all the batteries are equalized, for example, voltage differences between all the batteries are all within a preset voltage range. By controlling the target battery to be discharged and another battery to be charged, the voltage of the target battery can be quickly pulled down, so that voltages of N batteries connected in series are equalized. In addition, the energy is transferred between the batteries by using the winding and the magnetic core, so that interference signals may be isolated from each other, and isolation is high.

## Description

### TECHNICAL FIELD

This application relates to the field of power electronics technologies, and in particular, to an energy storage system, an uninterruptible power system, and a battery equalization method.

### BACKGROUND

At present, with advancement of science and technology, a battery string is used in multiple industries, for example, a data center, an electric vehicle, and a photovoltaic storage system. In particular, as a data amount keeps increasing in various industries, the data center becomes more important. The data center generally includes a plurality of servers. The server cannot be powered off during running. For example, when a mains supply is cut off, an uninterruptible power system (Uninterruptible Power System, UPS) is required to replace the mains supply to continuously supply power to the server. In addition, to ensure normal running of the server, a running environment of the server has a high requirement for temperature. Generally, the data center is equipped with a computer room air conditioner, and the computer room air conditioner also requires a power supply to keep running. When the mains supply fails, the UPS is also required to supply power to the computer room air conditioner.

The UPS includes a battery string. The battery string includes a plurality of batteries connected in series. For example, a common battery includes a lead-acid battery (Valve-Regulated Lead-Acid, VRLA) or a lithium iron phosphate (LiFePo4, LFP) battery. Because a voltage of a single battery is low, for example, 2 V, 3.2 V, 6 V, or 12 V, in actual use, a plurality of (dozens of to hundreds of) batteries need to be connected in series to form a battery string. Generally, the batteries connected in series have a same specification, for example, are all 6 V batteries. When the batteries work for a long time, there may be a large difference between the batteries connected in series. It is difficult to ensure that voltages of the batteries continue to be consistent, that is, the voltages are no longer all 6 V This affects an overall feature of the battery string. For example, some batteries are not fully charged or discharged. As a result, power supply efficiency of the batteries is affected.

Therefore, the battery string needs to equalize the voltages of the batteries, so that the voltages of the batteries connected in series are consistent as much as possible, thereby improving power supply efficiency of the batteries.

### SUMMARY

To resolve the foregoing technical problem, this application provides an energy storage system, an uninterruptible power system, and a battery equalization method, to equalize voltages of a plurality of batteries connected in series, thereby improving power supply efficiency of the batteries.

An embodiment of this application provides an energy storage system, including a controller, N batteries, N bidirectional power converters, and N windings, where N is an integer greater than or equal to 2. In the energy storage system, the N batteries are connected in series, and the N windings share a same magnetic core. That is, the N windings are wound around the same magnetic core, and the N batteries, the N bidirectional power converters, and the N windings are in a one-to-one correspondence. That is, two terminals of an i^{th} battery in the N batteries are connected to a first port of an i^{th} bidirectional power converter in the N bidirectional power converters, and a second port of the i^{th} bidirectional power converter is connected to an i^{th} winding in the N windings, where i is any integer of 1 to N.

The controller is configured to separately transfer energy of a target battery to the magnetic core by using a target bidirectional power converter and a target winding, and charge another battery other than the target battery in the N batteries by using the magnetic core, so that voltages of the N batteries are equalized. The voltage of the target battery is greater than those of some or all batteries other than the target battery in the N batteries. The target battery may be one or more batteries.

In this embodiment, the voltages of the N batteries being equalized may be that the voltages of the N batteries are finally completely the same, or may be that the voltages of the N batteries meet a preset equalization condition. For example, if a voltage difference between any two batteries is within a preset voltage difference range, it is considered that the voltages of the N batteries are equalized, that is, there is a specific tolerance range.

In the energy storage system, each bidirectional power converter includes two ports. Each port includes a first terminal and a second terminal. Each bidirectional power converter may implement bidirectional energy flow, that is, may transfer the energy from the winding to the battery, or may transfer the energy from the battery to the winding. When the voltage of the battery corresponding to the bidirectional power converter is high, the bidirectional power converter transfers the energy of the battery to the winding, to transfer the energy from the winding to another battery, thereby achieving voltage equalization between the N batteries.

In a possible implementation, when controlling the energy of the target battery in the N batteries to be transferred to the magnetic core, the controller controls only the energy of the target battery with a highest voltage in the N batteries to be transferred to the magnetic core by using the corresponding target bidirectional power converter and the target winding, and charges other N-1 batteries in the N batteries by using the magnetic core, so that the voltages of the N batteries are equalized.

The controller controls only one battery to be discharged and other batteries to be all charged at a same time, so that the battery transfers the energy to all the other batteries at the same time. In this way, the energy of the battery with the highest low voltage can be quickly reduced, so that the voltages of the N batteries are quickly equalized. A control logic of this solution is simple. In addition, in the energy storage system, the energy is transferred between the batteries by using the winding and the magnetic core, so that interference signals may be isolated from each other.

In a possible implementation, when controlling the battery to be charged or discharged by using the bidirectional power converter, the controller selects the target battery with the highest voltage based on the voltages of the N batteries, controls a corresponding target bidirectional power converter of the target battery to perform power conversion, to transfer the energy of the target battery to the magnetic core by using the corresponding target bidirectional power converter and the target winding, and controls a corresponding bidirectional power converter of the another battery other than the target battery in the N batteries to receive the energy from the corresponding winding, to work in a freewheeling state.

In a possible implementation, the controller periodically selects the target battery with the highest voltage from the N batteries, and controls the corresponding target bidirectional power converter of the target battery to perform power conversion. As the battery is charged and discharged, the voltage of the battery with the highest original voltage decreases, and the voltage of the another battery increases. Therefore, the battery with the highest voltage in the N batteries may change. Therefore, after a preset period of time, the controller selects a new target battery with a highest voltage based on the voltages of the N batteries, controls a corresponding target bidirectional power converter of the target battery to perform power conversion, and controls a corresponding power converter of another battery other than the target battery in the N batteries to work in the freewheeling state. The rest may be deduced by analogy until the voltages of the N batteries are equalized.

The battery with the highest voltage is periodically selected to be discharged, so that the energy of one battery is transferred to all other batteries at the same time. In this way, the energy of the battery with the highest voltage can be quickly reduced until the voltages of the N batteries are equalized.

In a possible implementation, the i^{th} bidirectional power converter in the energy storage system includes a full-bridge circuit. The full-bridge circuit includes a first bridge arm and a second bridge arm that are connected in parallel. A midpoint of the first bridge arm is connected to a first terminal of a target winding. A midpoint of the second bridge arm is connected to a second terminal of the target winding.

The first bridge arm includes a first switching transistor and a fourth switching transistor that are connected in series. The second bridge arm includes a second switching transistor and a third switching transistor that are connected in series. A first terminal of the first switching transistor and a first terminal of the second switching transistor are both connected to a positive terminal of a first battery. A second terminal of the first switching transistor is connected to a first terminal of the fourth switching transistor. A second terminal of the fourth switching transistor and a second terminal of the third switching transistor are both connected to a negative terminal of the first battery. A second terminal of the second switching transistor is connected to a first terminal of the third switching transistor. The first switching transistor, the second switching transistor, the third switching transistor, and the fourth switching transistor each include an anti-parallel diode. The first switching transistor and a corresponding anti-parallel diode are used as an example for description. When a current of the i^{th} battery forward flows through the first switching transistor, a current direction of the first switching transistor is opposite to a current direction in which the anti-parallel diode is turned on.

When controlling the target battery to be discharged, the controller controls the first switching transistor and the second switching transistor to be alternately turned on, the third switching transistor and the first switching transistor to synchronously work, and the fourth switching transistor and the second switching transistor to synchronously work, that is, when the first switching transistor and the third switching transistor are simultaneously turned on, the second switching transistor and the fourth switching transistor are simultaneously turned off, or when the first switching transistor and the third switching transistor are simultaneously turned off, the second switching transistor and the fourth switching transistor are simultaneously turned on, so that the target bidirectional power converter performs power conversion. When the controller controls the another battery other than the target battery in the N batteries to be charged, the first switching transistor, the second switching transistor, the third switching transistor, and the fourth switching transistor are all controlled to be turned off, so that another bidirectional power converter other than the target bidirectional power converter in the N bidirectional power converters works in the freewheeling state by using the anti-parallel diode, to charge the another battery.

In the energy storage system provided in this embodiment, each bidirectional power converter may include a full-bridge circuit. Bidirectional energy flow is implemented by controlling on/off states of the four switching transistors, that is, the energy may be transferred from the winding to the battery, or may be transferred from the battery to the winding. The controller controls only the battery with the highest voltage to transfer the energy to the another battery by using the bidirectional power converter at a same time, that is, the battery with the highest voltage is discharged, and the another battery is charged. In this way, the energy of the battery with the highest voltage can be quickly reduced, so that the voltages of the N batteries are quickly equalized. In addition, the full-bridge circuit can implement forward discharging and reverse discharging of the battery with the highest voltage, so that electric energy conversion efficiency is high.

In a possible implementation, when controlling the another battery other than the target battery in the N batteries to be charged, the controller may further control the first switching transistor and the third switching transistor to be both turned on and the second switching transistor and the fourth switching transistor to be both turned off, so that the another bidirectional power converter other than the target bidirectional power converter in the N bidirectional power converters works in the freewheeling state by using the turned-on first switching transistor and third switching transistor. Alternatively, the controller controls the second switching transistor and the fourth switching transistor to be both turned on and the first switching transistor and the third switching transistor to be both turned off, so that the another bidirectional power converter other than the target bidirectional power converter in the N bidirectional power converters works in the freewheeling state by using the turned-on second switching transistor and fourth switching transistor, to charge the another battery other than the target battery in the N batteries.

When the controller controls the four switching transistors to be all turned off, and charges the another battery other than the target battery by using the anti-parallel diode, a voltage drop caused by the turned-on anti-parallel diode is large, resulting in a large energy loss of the battery. However, when the controller controls the switching transistors to be alternately turned on to charge the another battery, a voltage drop caused by the turned-on switching transistor is less than the voltage drop caused by the turned-on diode, so that the energy loss of the battery is reduced.

Each battery corresponds to one bidirectional power converter. The full-bridge circuit is used as an example, when one battery is short-circuited because the switching transistor in the full-bridge circuit performs a misoperation or is faulty, only the battery is short-circuited, and normal working of another battery is not affected. For example, the first switching transistor and the fourth switching transistor in the corresponding target bidirectional power converter of the target battery are both turned on, so that the target battery is short-circuited, and working of another battery is not affected. In addition, because each battery corresponds to one bidirectional power converter, a voltage borne by the bidirectional power converter is a voltage of one battery. A switching transistor of the bidirectional power converter bears a low voltage. This facilitates selection of the switching transistor in the bidirectional power converter. Only the switching transistor with a low withstand voltage needs to be selected, so that costs are reduced.

In a possible implementation, the i^{th} bidirectional power converter in the energy storage system includes a half-bridge circuit. The half-bridge circuit includes a fifth switching transistor, a sixth switching transistor, and a capacitor.

A first terminal of the fifth switching transistor is connected to a positive terminal of the i^{th} battery. A second terminal of the fifth switching transistor is connected to a first terminal of the sixth switching transistor. A second terminal of the sixth switching transistor is connected to a negative terminal of the i^{th} battery. The fifth switching transistor and the sixth switching transistor each include an anti-parallel diode. The second terminal of the fifth switching transistor is connected to a first terminal of the target winding. A first terminal of the capacitor is connected to a second terminal of the target winding. A second terminal of the capacitor is connected to the second terminal of the sixth switching transistor.

When controlling the target battery to be discharged, the controller controls the fifth switching transistor and the sixth switching transistor to be alternately turned on, so that the target bidirectional power converter performs power conversion. When controlling the another battery other than the target battery in the N batteries to be charged, the controller controls the fifth switching transistor and the sixth switching transistor to be both turned off, so that another bidirectional power converter other than the target bidirectional power converter in the N bidirectional power converters works in the freewheeling state by using the anti-parallel diode.

In a possible implementation, when the controller controls the another battery other than the target battery to be charged, the controller controls the fifth switching transistor to be turned on and the sixth switching transistor to be turned off, so that a corresponding bidirectional power converter of the another battery works in the freewheeling state by using the fifth switching transistor. Alternatively, the controller controls the sixth switching transistor to be turned on and the fifth switching transistor to be turned off, so that a corresponding bidirectional power converter of the another battery works in the freewheeling state by using the sixth switching transistor, to charge the another battery.

When the controller controls the fifth switching transistor and the sixth switching transistor to be both turned off, and charges the battery by using the anti-parallel diode, a voltage drop caused by the turned-on anti-parallel diode is large, resulting in a large energy loss of the battery. However, when the controller controls the fifth switching transistor and the sixth switching transistor to be alternately turned on to charge the another battery, a voltage drop caused by the turned-on switching transistor is less than the voltage drop caused by the turned-on anti-parallel diode, so that the energy loss of the battery is reduced. In addition, the battery is discharged by controlling the switching transistors in the half-bridge circuit to be alternately turned on. Compared with the full-bridge circuit, the half-bridge circuit requires fewer switching transistors, costs are lower, and a control logic of the controller is simpler. However, compared with the full-bridge circuit, the half-bridge circuit has lower energy transfer efficiency, which is half of that of the full-bridge circuit.

Each battery corresponds to one bidirectional power converter. The half-bridge circuit is used as an example, when one battery is short-circuited because the switching transistor in the half-bridge circuit performs a misoperation or is faulty, only the battery is short-circuited, and normal working of another battery is not affected. For example, the fifth switching transistor and the sixth switching transistor in the corresponding target bidirectional power converter of the target battery are both turned on, so that the target battery is short-circuited, and working of another battery is not affected. In addition, because each battery corresponds to one bidirectional power converter, a voltage borne by the bidirectional power converter is a voltage of one battery. A switching transistor of the bidirectional power converter bears a low voltage. This facilitates selection of the switching transistor in the bidirectional power converter. Only the switching transistor with a low withstand voltage needs to be selected, so that costs are reduced.

In a possible implementation, if rated voltage values of any two batteries in the N batteries of the energy storage system are the same, a turn ratio of any two windings in the N windings is 1:1.

In a possible implementation, if a ratio of rated voltage values of two batteries in the N batteries of the energy storage system is a:b, a turn ratio of windings respectively corresponding to the two batteries is a:b.

In a possible implementation, the energy storage system further includes a voltage sensor, configured to: detect a voltage of each of the N batteries, and send the detected voltage of each battery to the controller.

In a possible implementation, in the N batteries of the energy storage system, each battery includes a plurality of cells. Two ends of each cell in the plurality of cells are connected in parallel to a balanced branch. The balanced branch includes a switch and a resistor that are connected in series.

The controller is configured to: when a voltage of the cell is greater than a preset voltage, control the switch in the balanced branch to be turned on, so that the resistor consumes energy of the cell, thereby reducing the voltage of the cell.

An embodiment of this application provides an uninterruptible power system, including a rectifier circuit, an inverter circuit, and the energy storage system according to any one of the foregoing implementations.

An input terminal of the rectifier circuit is configured to be connected to an alternating current power supply. An output terminal of the rectifier circuit is connected to a direct current bus.

An input terminal of the inverter circuit is connected to the direct current bus. An output terminal of the inverter circuit is configured to provide an alternating current to a load. The N batteries are connected in series to the direct current bus.

An embodiment of this application further provides a battery equalization method. The method is applied to N batteries connected in series. The N batteries correspond to N bidirectional power converters and N windings. Two terminals of an i^{th} battery in the N batteries are connected to a first port of an i^{th} bidirectional power converter in the N bidirectional power converters. A second port of the i^{th} bidirectional power converter is connected to an i^{th} winding in the N windings, where i is any integer of 1 to N. The N windings share a same magnetic core. The method includes:
separately transferring energy of a target battery in the N batteries to the magnetic core by using a target bidirectional power converter and a target winding, and charging another battery other than the target battery in the N batteries by using the magnetic core, so that voltages of the N batteries are equalized. The voltage of the target battery is greater than those of some or all batteries other than the target battery in the N batteries. The target battery may be one or more batteries.

In a possible implementation, the transferring energy of a target battery in N batteries to the magnetic core by using a target bidirectional power converter and a target winding separately specifically includes:
transferring the energy of the target battery with a highest voltage in the N batteries to the magnetic core by using the target bidirectional power converter and the target winding.

In a possible implementation, the separately transferring the energy of the target battery with a highest voltage in the N batteries to the magnetic core by using the target bidirectional power converter and the target winding, and charging another battery other than the target battery in the N batteries by using the magnetic core specifically includes:
selecting, based on the voltages of the N batteries, a battery with a highest voltage as the target battery;
controlling the corresponding target bidirectional power converter of the target battery to perform power conversion, to transfer the energy of the target battery to the magnetic core;
controlling a corresponding bidirectional power converter of the another battery other than the target battery in the N batteries to work in a freewheeling state, to charge the another battery.

An embodiment further provides an equalization system, including a controller, N bidirectional power converters, and N windings. N is an integer greater than or equal to 2. The equalization system is configured to equalize voltages of N batteries connected in series.

The N windings share a magnetic core.

Two terminals of an i^{th} battery in the N batteries are connected to a first port of an i^{th} bidirectional power converter in the N bidirectional power converters. A second port of the i^{th} bidirectional power converter is connected to an i^{th} winding in the N windings.

The controller is configured to separately transfer energy of a target battery to the magnetic core by using a target bidirectional power converter and a target winding, and charge another battery other than the target battery in the N batteries by using the magnetic core, so that the voltages of the N batteries are equalized. The voltage of the target battery is greater than those of some or all batteries other than the target battery in the N batteries.

Beneficial effects of the uninterruptible power system, the battery equalization method, and the equalization system provided in embodiments of this application are the same as a beneficial effect of the energy storage system provided in this embodiment of this application. Details are not described herein again. This application has at least the following advantages:

The energy storage system includes a plurality of bidirectional power converters and a plurality of windings. The plurality of windings share the same magnetic core. Each bidirectional power converter may implement bidirectional energy flow, that is, may flow from the winding to the battery, or may flow from the battery to the winding. The controller controls the target battery to transfer the energy to another battery by using the target bidirectional power converter at a same time. The voltage of the target battery is greater than those of some or all batteries other than the target battery in the N batteries, that is, a high-voltage battery is discharged, and another battery is charged. As the battery is charged and discharged, a high-voltage battery may change. The controller needs to find a new target battery to continue discharging until voltages of all batteries are equalized, that is, the voltages of all the batteries are consistent. For example, voltage differences between all the batteries are all within a preset voltage range, it is considered that the voltages of all the batteries are the same. The target battery is controlled to be discharged, and another battery is controlled to be charged at a same time. In this way, the voltage of the target battery can be quickly pulled down, so that the voltages of the N batteries connected in series can be quickly equalized. In addition, in the energy storage system, the energy is transferred between the batteries by using the winding and the magnetic core, so that interference signals may be isolated from each other, and isolation is high.

### BRIEF DESCRIPTION OF DRAWINGS

FIG. 1 is a schematic diagram of a UPS according to an embodiment of this application;
FIG. 2 is a schematic diagram of a structure of batteries connected in series according to an embodiment of this application;
FIG. 3 is a schematic diagram of an energy storage system according to an embodiment of this application;
FIG. 4 is a schematic diagram of a working principle of a controller according to an embodiment of this application;
FIG. 5 is a schematic diagram of a logic for battery charging and discharging according to an embodiment of this application;
FIG. 6 is a schematic diagram of an energy storage system including a full-bridge circuit according to an embodiment of this application;
FIG. 7 is a schematic diagram of another energy storage system including a full-bridge circuit according to an embodiment of this application;
FIG. 8 is a schematic diagram of a drive signal according to an embodiment of this application;
FIG. 9 is a schematic diagram of an energy storage system including a half-bridge circuit according to an embodiment of this application;
FIG. 10 is a schematic diagram of another drive signal according to an embodiment of this application;
FIG. 11 is a structural diagram of an interior of a battery according to an embodiment of this application;
FIG. 12 is a schematic diagram of a UPS according to an embodiment of this application; and
FIG. 13 is a flowchart of a battery equalization method according to an embodiment of this application.

### DESCRIPTION OF EMBODIMENTS

The following describes the technical solutions in embodiments of this application with reference to the accompanying drawings in embodiments of this application.

The following terms "first", "second", and the like are merely intended for a purpose of description, and shall not be understood as an indication or implication of relative importance or implicit indication of a quantity of indicated technical characteristics. Therefore, a feature limited by "first", "second", or the like may explicitly or implicitly include one or more features. In the descriptions of this application, unless otherwise stated, "a plurality of" means two or more than two.

In this application, it should be noted that the term "connection" should be understood in a broad sense unless otherwise expressly specified and limited. For example, the "connection" may be a fixed connection, may be a detachable connection, may be an integral connection; may be a direct connection, or may be an indirect connection implemented by using a medium. In addition, a term "coupling" may be a manner of implementing an electrical connection for signal transmission. The "coupling" may be a direct electrical connection, or may be an indirect electrical connection through an intermediate medium.

To enable a person skilled in the art to better understand the technical solutions provided in embodiments of this application, the following first describes an application scenario of the technical solutions with reference to the accompanying drawings.

This embodiment of this application relates to an energy storage system. The energy storage system includes a plurality of batteries connected in series. The energy storage system may provide a direct current. For example, the energy storage system may be applied to a UPS, or may be applied to a power battery string of an electric vehicle, or may be applied to a battery rack in a photovoltaic storage system. A specific application scenario of the energy storage system is not limited in this embodiment of this application. The following uses an example in which the energy storage system is applied to the UPS for description.

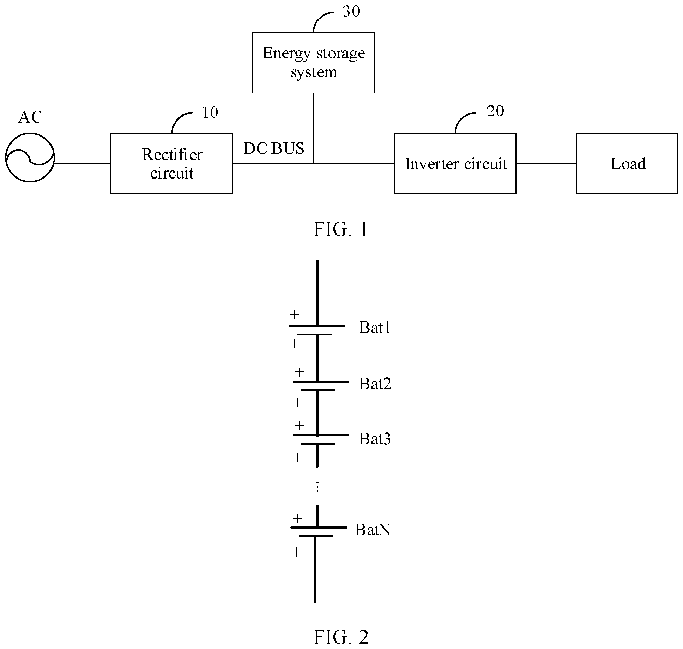

FIG. 1 is a schematic diagram of a UPS according to an embodiment of this application.

Generally, the UPS includes a rectifier circuit 10 and an inverter circuit 20. In an implementation, the UPS may further include an energy storage system 30. There may be two types of UPSs. One is that the UPS provides energy storage. For example, the UPS includes an energy storage battery. The other is that the UPS does not provide energy storage, that is, an energy storage battery is externally connected.

An input terminal of the rectifier circuit 10 is configured to be connected to an alternating current AC power supply, for example, a mains supply 220 V An output terminal of the rectifier circuit 10 is connected to a direct current bus DC BUS.

An input terminal of the inverter circuit 20 is connected to the direct current bus DC BUS. The energy storage system 30 is connected to the direct current bus DC BUS. An output terminal of the inverter circuit 20 is configured to provide an alternating current to a load. For example, the load is a computer room air conditioner of a data center, or a server of a data center.

When the alternating current AC power supply normally supplies power, the alternating current AC power supply supplies power to the load. In addition, the rectifier circuit 10 rectifies an alternating current provided by the alternating current AC power supply to a direct current to charge a battery string in the energy storage system 30.

When the alternating current AC power supply is powered off, the battery string in the energy storage system 30 supplies power to the load. Specifically, the inverter circuit 20 converts a direct current provided by the battery string in the energy storage system 30 into an alternating current to supply power to the load, to implement uninterruptible power supply for the load and ensure normal running of the load.

With reference to the accompanying drawings, the following describes an implementation in which a plurality of batteries in the energy storage system 30 are connected in series. Because a voltage of a single battery is low, in an actual application, the plurality of batteries need to be connected in series to form a battery string.

FIG. 2 is a schematic diagram of a structure of the batteries connected in series according to an embodiment of this application.

As shown in FIG. 2, the battery string includes N batteries connected in series. N is an integer greater than or equal to 2. For ease of description, a first battery, a second battery, a third battery, ..., and an N^{th} battery are respectively marked as Bat1, Bat2, Bat3, ..., and BatN. Bat is short for battery (battery). It can be learned from FIG. 2 that a positive terminal of the first battery Bat1 is used as a positive terminal of the battery string, a negative terminal of the first battery Bat1 is connected to a positive terminal of the second battery Bat2, a negative terminal of the second battery Bat2 is connected to a positive terminal of the third battery Bat3, and so on, until a negative terminal of the N^{th} battery BatN is used as a negative terminal of the battery string.

Generally, the batteries connected in series have a same specification. For example, rated voltage values of all the batteries are the same. However, as a working time increases, there may be a large difference between actual voltages of the batteries connected in series, and it is difficult to ensure that voltages of all the batteries are equalized. Consequently, some batteries may not be fully charged and discharged, and power supply efficiency of the batteries is affected.

To equalize voltages of all batteries in a battery string, an embodiment of this application provides an energy storage system. The energy storage system includes: a controller, N batteries, N bidirectional power converters, and N windings. The controller controls a target battery in the battery string to transfer energy to another battery by using a target bidirectional power converter. A voltage of the target battery is greater than those of some or all batteries other than the target battery in the N batteries. The target battery may be one or more batteries. That is, the controller controls a high-voltage battery to be discharged and another low-voltage battery to be charged at a same time. After a preset period of time, the controller selects a new target battery to be discharged, and so on. In this way, battery voltage equalization is quickly implemented.

It should be noted that, when the controller controls the target battery to be discharged, in a possible implementation, the controller controls only the target battery with a highest voltage in the battery string to be discharged and the another battery to be charged.

In the energy storage system provided in this embodiment, the N batteries are connected in series. The N windings share a same magnetic core, that is, the N windings are wound around the same magnetic core. The N batteries, the N bidirectional power converters, and the N windings are in a one-to-one correspondence, that is, two terminals of an i^{th} battery in the N batteries are connected to a first port of an i^{th} bidirectional power converter in the N bidirectional power converters, and a second port of the i^{th} bidirectional power converter is connected to an i^{th} winding in the N windings, where i is any integer of 1 to N. That is, the i^{th} battery is any one of the N batteries, the i^{th} bidirectional power converter is any one of the N bidirectional power converters, and the i^{th} winding is any one of the N windings.

The controller is configured to separately transfer energy of the target battery in the N batteries to the magnetic core by using the target bidirectional power converter and a target winding, and charge another battery in the N batteries by using the magnetic core, so that voltages of the N batteries are equalized. The voltage of the target battery is greater than those of some or all batteries other than the target battery in the N batteries.

In the energy storage system provided in this embodiment, each bidirectional power converter includes two ports. Each port includes a first terminal and a second terminal. Each bidirectional power converter may implement bidirectional energy flow, that is, may transfer the energy from the winding to the battery, or may transfer the energy from the battery to the winding. When a voltage of a battery corresponding to the bidirectional power converter is high, the bidirectional power converter transfers the energy from the battery to the winding, to transfer the energy from the winding to another battery.

The following describes in detail a working principle of the energy storage system provided in this embodiment of this application by using an example in which the controller controls the target battery with the highest voltage to be discharged.

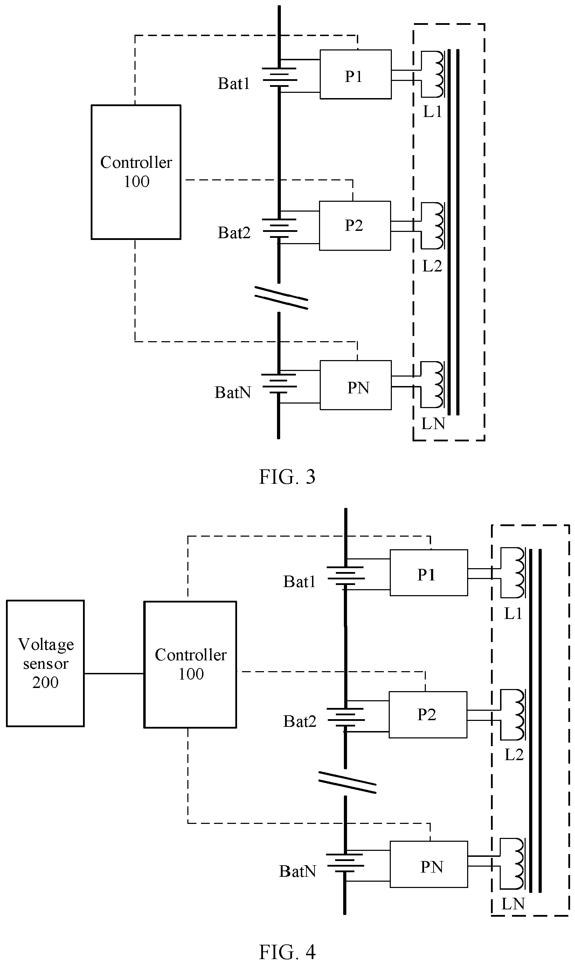

FIG. 3 is a schematic diagram of an energy storage system according to an embodiment of this application.

A positive terminal of a first battery Bat1 is connected to a first terminal of a first port of a first bidirectional power converter P1. A negative terminal of the first battery Bat1 is connected to a second terminal of the first port of the first bidirectional power converter P1. A first terminal of a second port of the first bidirectional power converter P1 is connected to a first terminal of a first winding L1. A second terminal of the second port of the first bidirectional power converter P1 is connected to a second terminal of the first winding L1. Similarly, a positive terminal of a second battery Bat2 is connected to a first terminal of a first port of a second bidirectional power converter P2. A negative terminal of the second battery Bat2 is connected to a second terminal of the first port of the second bidirectional power converter P2. A first terminal of a second port of the second bidirectional power converter P2 is connected to a first terminal of a second winding L2. A second terminal of the second port of the second bidirectional power converter P2 is connected to a second terminal of the second winding L2. By analogy, a positive terminal of an N^{th} battery BatN is connected to a first terminal of a first port of an N^{th} bidirectional power converter PN. A negative terminal of the N^{th} battery BatN is connected to a second terminal of the first port of the N^{th} bidirectional power converter PN. A first terminal of a second port of the N^{th} bidirectional power converter PN is connected to a first terminal of an N^{th} winding LN. A second terminal of the second port of the N^{th} bidirectional power converter PN is connected to a second terminal of the N^{th} winding LN.

In the energy storage system, the voltage of the target battery is a voltage of a battery with a highest voltage in the N batteries. The controller 100 transfers the energy of the target battery in the N batteries to the magnetic core by using the corresponding target bidirectional power converter and the target winding. The windings L1 to LN are all wound around the same magnetic core. When one winding releases energy, it is equivalent to a primary-side winding of a transformer, and the other N-1 windings are equivalent to secondary-side windings of the transformer. That is, the primary-side winding transfers energy to the secondary-side windings, so that the other N-1 batteries in the N batteries are charged by using the magnetic core, and the voltages of the N batteries are equalized.

The voltages of the N batteries being equalized may be that the voltages of the N batteries are finally completely the same, or may be that the voltages of the N batteries meet a preset equalization condition. For example, if a voltage difference between any two batteries is within a preset voltage difference range, it is considered that the voltages of the N batteries are equalized, that is, there is a specific tolerance range.

A manner of obtaining the battery voltage is not limited in this embodiment of this application. In a possible implementation, a voltage sensor is used to detect a voltage of each of the N batteries, and send the detected voltage of each battery to the controller.

The following describes a working principle of the controller in detail with reference to FIG. 4.

FIG. 4 is a schematic diagram of the working principle of the controller according to an embodiment of this application.

The voltage sensor 200 is configured to detect the voltage of each of the N batteries and send the detected voltage of each battery to the controller 100. One battery may correspond to one voltage sensor, or N batteries may correspond to a group of integrated voltage sensors.

It is assumed that in the energy storage system, the voltage sensor 200 detects that a current battery with a highest voltage is the first battery Bat1. In this case, the controller 100 transfers energy of the first battery Bat1 to the magnetic core by using the corresponding first bidirectional power converter P1 and first winding L1, and the first battery Bat1 is discharged to reduce the voltage. In addition, the controller 100 controls a corresponding bidirectional power converter of another battery to receive energy from a corresponding winding, to increase voltage of the another battery through charging. That is, the corresponding bidirectional power converters of the second battery Bat2 to the N^{th} battery BatN respectively receive energy from the corresponding windings, to increase the voltages of the second battery Bat2 to the N^{th} battery BatN through charging. It should be understood that, in this case, the first winding L 1 is used as the primary-side winding of the transformer, and the second winding L2 to the N^{th} winding LN are used as the secondary-side windings of the transformer. Energy is transferred from the primary-side winding to the secondary-side windings, and the energy of a high-voltage battery is transferred to a low-voltage battery, so that the voltages of the batteries are equalized. This process may be repeated several cycles to complete voltage equalization of the N batteries.

As the battery is charged and discharged, after a period of time, the battery with the highest voltage may change. The controller 100 needs to select a new battery with a highest voltage based on the voltage of each battery, to control the battery with the highest voltage to be discharged.

For example, in a possible case, after a preset period of time, the voltage sensor 200 detects that a voltage of the second battery Bat2 is the highest. In this case, the controller 100 transfers energy of the second battery Bat2 to the magnetic core by using the corresponding second bidirectional power converter P2 and second winding L2, and the second battery Bat2 is discharged to reduce the voltage. In addition, the controller controls another battery in the N batteries to receive energy by using a corresponding bidirectional power converter, to increase the voltage of the another battery through charging.

In a possible implementation, at a preset time interval, the controller 100 controls a new battery with a highest voltage to be discharged and another battery to be charged until it is detected that the voltages of the N batteries are equalized.

It should be noted that in this embodiment, it is assumed that the first battery and the second battery each have a highest voltage. This is merely an example for description, does not affect implementation of the working principle of the controller, and does not constitute any form limitation on this application.

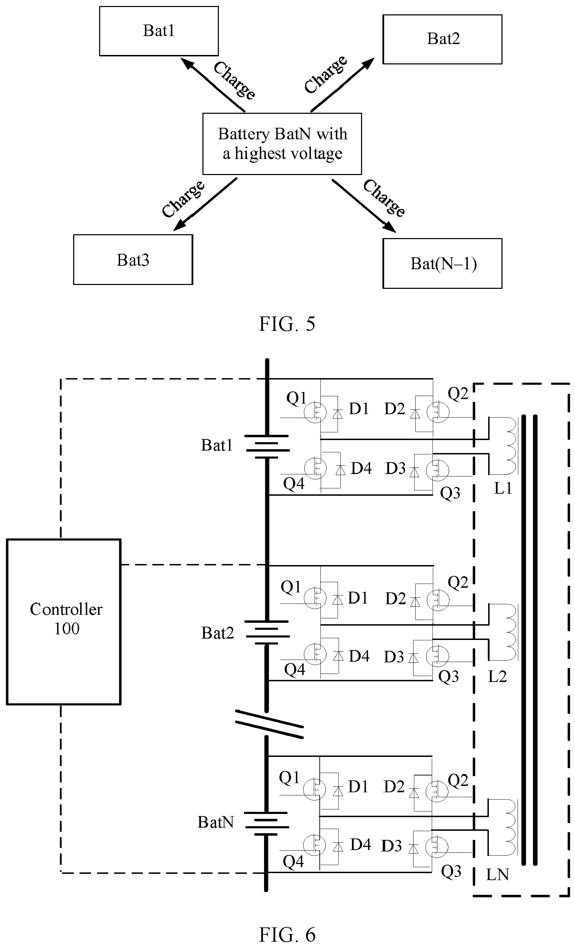

The following describes a control logic for charging and discharging the N batteries with reference to FIG. 5.

FIG. 5 is a schematic diagram of a logic for battery charging and discharging according to an embodiment of this application.

In the N batteries, the controller controls a battery BatN with a highest voltage to be discharged to reduce a voltage of the battery BatN, and other N-1 batteries to be charged to increase voltages of the other N-1 batteries, that is, the first battery Bat1, the second battery Bat2, ..., and the (N-1)^{th} battery Bat(N-1) are all charged. After a preset period of time, the controller selects a new battery BatN with a highest voltage to be discharged, and charges other N-1 batteries, and so on, until the voltages of the N batteries are equalized.

According to the energy storage system provided in this embodiment, the controller controls the battery with the highest voltage in the N batteries to be discharged, transfers energy of the battery with the highest voltage to the magnetic core by using a corresponding bidirectional power converter and winding, and charges another battery in the N batteries by using the bidirectional power converter. As the battery is charged and discharged, the battery with the highest voltage may change after a period of time. In this case, the controller selects a new battery with a highest voltage to be discharged, and another battery is charged, to implement bidirectional energy flow. The rest may be deduced by analogy until the voltages of the N batteries are equalized. The controller controls only one battery to be discharged and other batteries to be all charged at a same time, so that the battery transfers energy to all the other batteries at the same time. In this way, the energy of the battery with the highest voltage can be quickly reduced, so that the voltages of the N batteries are quickly equalized. This solution is easy to control. In addition, in the energy storage system, the energy is transferred between the batteries by using the winding and the magnetic core, so that interference signals may be isolated from each other.

When the controller controls the battery to be charged or discharged by using the bidirectional power converter in a specific implementation: The controller selects the battery with the highest voltage based on the voltages of the N batteries, controls a corresponding bidirectional power converter of the battery with the highest voltage to perform power conversion, to transfer energy of the battery with the highest voltage to the magnetic core by using the corresponding bidirectional power converter and winding, and controls corresponding bidirectional power converters of other batteries in the N batteries to stop power conversion and to receive the energy from corresponding windings by using the corresponding bidirectional power converters, so as to work in a freewheeling state.

As the battery is charged and discharged, the voltage of the battery with the highest original voltage decreases, and the voltage of the another battery increases. Therefore, the battery with the highest voltage in the N batteries may change. Therefore, after a preset period of time, the controller selects a new battery with a highest voltage based on the voltages of the N batteries, controls a corresponding target bidirectional power converter of the battery with the highest voltage to perform power conversion, and controls a corresponding power converter of another battery in the N batteries to stop power conversion to work in the freewheeling state. The rest may be deduced by analogy until the voltages of the N batteries are equalized. That the bidirectional power converter works in the freewheeling state means that the bidirectional power converter does not perform power conversion, and only a current flows through the bidirectional power converter, to form a battery loop.

The controller may control, by using a drive signal, the bidirectional power converter to work, for example, send a square wave drive signal, and control the bidirectional power converter by changing an on/off state of a switching transistor in the bidirectional power converter. A type of the switching transistor in the bidirectional power converter is not limited in this embodiment. For example, the switching transistor may be a metal-oxide semiconductor field-effect transistor (Metal-Oxide-Semiconductor Field-Effect Transistor, MOSFET), or may be an insulated gate bipolar transistor (Insulated Gate Bipolar Transistor, IGBT).

In the energy storage system provided in this embodiment, a specific structural form of the bidirectional power converter is not limited. For example, the bidirectional power converter may be a full-bridge circuit or a half-bridge circuit.

The following describes a working principle of a bidirectional power converter including a full-bridge circuit with reference to the accompanying drawings.

The energy storage system includes the controller, the N batteries, the N windings, and the N bidirectional power converters. The i^{th} bidirectional power converter includes a full-bridge circuit. The full-bridge circuit includes a first bridge arm and a second bridge arm that are connected in parallel.

The following describes in detail a specific connection manner of the full-bridge circuit with reference to FIG. 6.

FIG. 6 is a schematic diagram of an energy storage system including the full-bridge circuit according to an embodiment of this application.

As shown in FIG. 6, in the corresponding full-bridge circuit of the first battery Bat1, a first bridge arm includes a first switching transistor Q1 and a fourth switching transistor Q4 that are connected in series. A second bridge arm includes a second switching transistor Q2 and a third switching transistor Q3 that are connected in series. A first terminal of the first switching transistor Q1 and a first terminal of the second switching transistor Q2 are both connected to a positive terminal of the first battery Bat1. A second terminal of the first switching transistor Q1 is connected to a first terminal of the fourth switching transistor Q4. A second terminal of the second switching transistor Q2 is connected to a first terminal of the third switching transistor Q3. A second terminal of the fourth switching transistor Q4 and a second terminal of the third switching transistor Q3 are both connected to a negative terminal of the first battery Bat1. The first switching transistor Q1, the second switching transistor Q2, the third switching transistor Q3, and the fourth switching transistor Q4 each include an anti-parallel diode. The anti-parallel diodes respectively correspond to a diode D1, a diode D2, a diode D3, and a diode D4. A first terminal of the first winding L1 is connected to a midpoint of the first bridge arm. A second terminal of the first winding L1 is connected to a midpoint of the second bridge arm.

Similarly, connection manners of corresponding full-bridge circuits and windings of the second battery Bat2 to the N^{th} battery BatN are the same as that of the first battery Bat, and details are not described herein again.

In this embodiment, the target battery is a battery with a highest voltage in the N batteries. An example in which the controller controls the target battery to be discharged is used for description.

The controller 100 controls, based on the voltages of the N batteries, the corresponding target bidirectional power converter of the target battery with the highest voltage to perform power conversion, to transfer energy of the target battery to the magnetic core, and controls the corresponding bidirectional power converter of another battery other than the target battery to stop power conversion, to work in the freewheeling state. After a preset period of time, a new target battery with a highest voltage is selected, and a corresponding target bidirectional power converter is controlled to perform power conversion until the voltages of the N batteries are equalized.

In specific implementation, because the bidirectional power converter includes the full-bridge circuit, the controller 100 selects the corresponding full-bridge circuit of the target battery, and controls the first switching transistor Q1 and the second switching transistor Q2 in the full-bridge circuit to be alternately turned on, the third switching transistor Q3 and the first switching transistor Q1 to synchronously work, and the fourth switching transistor Q4 and the second switching transistor Q2 to synchronously work, that is, controls the first switching transistor Q1 and the third switching transistor Q3 to be turned on and the second switching transistor Q2 and the fourth switching transistor Q4 to be turned off, or controls the first switching transistor Q1 and the third switching transistor Q3 to be turned off and the second switching transistor Q2 and the fourth switching transistor Q4 to be turned on, so that the corresponding target bidirectional power converter of the target battery performs power conversion, to transfer energy to the magnetic core by using the corresponding target winding. In addition, in the corresponding full-bridge circuit of the another battery in the N batteries, the first switching transistor Q1, the second switching transistor Q2, the third switching transistor Q3, and the fourth switching transistor Q4 are all controlled to be turned off, so that the corresponding bidirectional power converter of the another battery stops power conversion, to work in the freewheeling state by using the anti-parallel diode, so as to charge the corresponding battery.

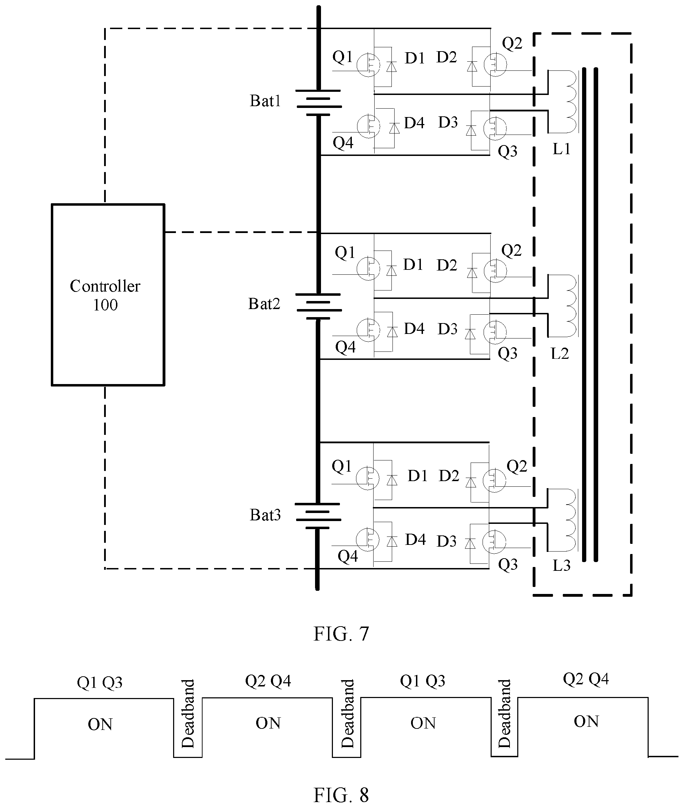

The following describes the working principle of the energy storage system including the full-bridge circuit with reference to FIG. 7 and FIG. 8.

FIG. 7 is a schematic diagram of another energy storage system including the full-bridge circuit according to an embodiment of this application.

The energy storage system provided in this embodiment includes three batteries connected in series, three windings, and three bidirectional power converters. Each bidirectional power converter includes one full-bridge circuit. The first battery Bat1, the second battery Bat2, and the third battery Bat3 respectively correspond to the first winding L1, the second winding L2, and the third winding L3. For structures and connection manners of corresponding full-bridge circuits of the first battery Bat1, the second battery Bat2, and the third battery Bat3, refer to the foregoing embodiment. Details are not described herein again. In this embodiment, the target battery is a battery with a highest voltage in the three batteries.

The controller may send the drive signal to the bidirectional power converter to control the on/off state of the switching transistor, thereby implementing battery charging and discharging.

FIG. 8 is a schematic diagram of the drive signal according to an embodiment of this application.

For example, the battery with the highest voltage is the first battery Bat1. The control logic of the controller for the first battery Bat1 is shown in FIG. 8. The controller controls, after a period of dead time, the first switching transistor Q1 and the second switching transistor Q2 to be alternately turned on, the third switching transistor Q3 and the first switching transistor Q1 to synchronously work, and the fourth switching transistor Q4 and the second switching transistor Q2 to synchronously work. Turn-on of the switching transistor corresponds to a high level in the drive signal, and dead time corresponds to a low level in the drive signal. It indicates that the four switching transistors are all in an off state.

It is assumed that a battery with a highest current voltage is the first battery Bat1, the controller 100 controls the first switching transistor Q1 and the third switching transistor Q3 in the corresponding full-bridge circuit of the first battery Bat1 to be turned on, and controls the second switching transistor Q2 and the fourth switching transistor Q4 in the corresponding full-bridge circuit to be turned off, so that a current of the first battery Bat1 starts from the positive terminal of the first battery Bat1, sequentially flows through the first switching transistor Q1, the first winding L1, and the third switching transistor Q3, and finally returns to the negative terminal of the first battery Bat1, and the energy of the first battery is forward discharged to the magnetic core. In this case, the first terminal of the first winding L1 is a positive terminal, and the second terminal of the first winding L1 is a negative terminal.

In addition, the controller 100 controls the first switching transistor Q1, the second switching transistor Q2, the third switching transistor Q3, and the fourth switching transistor Q4 in the corresponding full-bridge circuit of the second battery Bat2 to be all turned off. Because the second winding L2 and the first winding L1 share the magnetic core, the first terminal of the second winding L2 is also a positive terminal, and the second terminal of the second winding L2 is a negative terminal. A current of the second winding L2 starts from the first terminal of the second winding L2, flows through the diode D1, the second battery Bat2, and the diode D3, and returns to the second terminal of the second winding L2, to charge the second battery Bat2.

A principle of charging the third battery Bat3 by the controller 100 is the same as that of charging the second battery Bat2, and details are not described herein again.

After a period of dead time, the controller 100 controls the first switching transistor Q1 and the third switching transistor Q3 in the corresponding full-bridge circuit of the first battery Bat1 to be turned off, and controls the second switching transistor Q2 and the fourth switching transistor Q4 in the corresponding full-bridge circuit to be turned on, so that the current of the first battery Bat1 starts from the negative terminal of the first battery Bat1, sequentially flows through the fourth switching transistor Q4, the first winding L1, and the second switching transistor Q2, and finally returns to the positive terminal of the first battery Bat1, and the energy of the first battery Bat1 is reversely discharged to the magnetic core. In this case, the first terminal of the first winding L1 is a negative terminal, and the second terminal is a positive terminal.

In addition, the controller 100 controls the first switching transistor Q1, the second switching transistor Q2, the third switching transistor Q3, and the fourth switching transistor Q4 in the corresponding full-bridge circuit of the second battery Bat2 to be all turned off. Because the second winding L2 and the first winding L1 share the magnetic core, the first terminal of the second winding L2 is also a negative terminal, and the second terminal of the second winding L2 is a positive terminal. The current of the second winding L2 starts from the second terminal of the second winding L2, flows through the diode D2, the second battery Bat2, and the diode D4, and returns to the first terminal of the second winding L2, to charge the second battery Bat2.

A principle of charging the third battery Bat3 by the controller 100 is the same as that of charging the second battery Bat2, and details are not described herein again. It should be noted that, when the controller controls the first battery Bat1 to be discharged, whether the first switching transistor Q1 and the third switching transistor Q3 are first simultaneously turned on or off does not affect implementation of this embodiment. In another possible implementation, the controller 100 first controls the first switching transistor Q1 and the third switching transistor Q3 to be turned off and the second switching transistor Q2 and the fourth switching transistor Q4 to be turned on, and after a period of dead time, controls the first switching transistor Q1 and the third switching transistor Q3 to be turned on and the second switching transistor Q2 and the fourth switching transistor Q4 to be turned off.

As the battery is charged and discharged, after a period of time, the battery with the highest voltage may change. It is assumed that the second battery Bat2 has a highest voltage after a preset period of time, the controller 100 controls the corresponding second bidirectional power converter of the second battery Bat2 to perform power conversion, to transfer the energy of the second battery Bat2 to the magnetic core. In addition, the corresponding bidirectional power converters of the first battery Bat1 and the third battery Bat3 are controlled to stop power conversion, to work in the freewheeling state by using the anti-parallel diode. For a specific working principle, refer to the foregoing embodiment, and details are not described herein again.

In the energy storage system provided in this embodiment, each bidirectional power converter includes the full-bridge circuit. Bidirectional energy flow is implemented by controlling on/off states of the four switching transistors, that is, the energy may flow from the winding to the battery, or may flow from the battery to the winding. The controller controls only the battery with the highest voltage to transfer the energy to the another battery by using the bidirectional power converter at a same time, that is, the battery with the highest voltage is discharged, and the another battery is charged. In this way, the energy of the battery with the highest voltage can be quickly reduced, so that the voltages of the N batteries are quickly equalized. In addition, the full-bridge circuit can implement forward discharging and reverse discharging of the battery with the highest voltage, so that electric energy conversion efficiency is high.

In the foregoing embodiment, when a voltage of a battery is not the highest voltage, the controller needs to charge the battery. In this case, the controller controls the four switching transistors in the corresponding full-bridge circuit of the battery to be all turned off, to work in the freewheeling state by using the anti-parallel diode, so as to charge the battery.

In addition, in a possible implementation, when the battery is charged, the controller controls the first switching transistor and the second switching transistor to be alternately turned on, the third switching transistor and the first switching transistor to synchronously work, the fourth switching transistor and the second switching transistor to synchronously work. The winding transfers the energy to the battery by using the switching transistor. The following describes the working principle of the controller with reference to FIG. 7.

It is assumed that the battery with the highest current voltage is the first battery Bat1. For a principle of controlling discharging of the first battery Bat1 by the controller 100, refer to the foregoing embodiment. Details are not described herein again. The following describes a principle of charging the second battery Bat2 and the third battery Bat3.

When the first battery Bat1 is forward discharged, the first terminal of the first winding L1 is a positive terminal, and the second terminal of the first winding L1 is a negative terminal. Therefore, the first terminal of the second winding L2 is also a positive terminal, and the second terminal of the second winding L2 is a negative terminal. In addition, the controller 100 controls the first switching transistor Q1 and the third switching transistor Q3 of the second battery Bat2 to be turned on, and controls the second switching transistor Q2 and the fourth switching transistor Q4 to be turned off. In this case, the current of the second winding L2 starts from the first terminal of the second winding L2, sequentially flows through the first switching transistor Q1, the second battery Bat2, and the third switching transistor Q3, and finally returns to the second terminal of the second winding L2, to charge the second battery Bat2.

When the first battery Bat1 is reversely discharged, similarly, it can be learned that the first terminal of the second winding L2 is a negative terminal, and the second terminal is a positive terminal. In this case, the controller 100 controls the first switching transistor Q1 and the third switching transistor Q3 of the second battery Bat2 to be turned off, and controls the second switching transistor Q2 and the fourth switching transistor Q4 to be turned on. In this case, the current of the second winding L2 starts from the second terminal of the second winding L2, sequentially flows through the second switching transistor Q2, the second battery Bat2, and the fourth switching transistor Q4, and finally returns to the first terminal of the second winding L2, to charge the second battery Bat2.

A working principle of controlling charging of the third battery Bat3 by the controller 100 is the same as that of controlling charging of the second battery Bat2, and details are not described herein again.

When the controller controls the four switching transistors to be turned off, and charges the battery by using the diode, a voltage drop caused by the turned-on diode is large, resulting in a large energy loss of the battery. When the controller controls the switching transistors to be alternately turned on to charge the battery, a voltage drop caused by the turned-on switching transistor is less than the voltage drop caused by the turned-on diode, so that the energy loss of the battery is reduced.

In the energy storage system provided in this embodiment, each battery corresponds to one bidirectional power converter. The full-bridge circuit is used as an example. For example, when one battery is short-circuited because the switching transistor in the full-bridge circuit performs a misoperation or is faulty, only the battery is short-circuited, and normal working of another battery is not affected. For example, the first switching transistor and the fourth switching transistor in the corresponding bidirectional power converter of the first battery are both turned on, so that the first battery is short-circuited, and working of another battery is not affected. In addition, because each battery corresponds to one bidirectional power converter, a voltage borne by the bidirectional power converter is a voltage of one battery. A switching transistor of the bidirectional power converter bears a low voltage. This facilitates selection of the switching transistor in the bidirectional power converter. Only the switching transistor with a low withstand voltage needs to be selected, so that costs are reduced.

In the energy storage system provided in the foregoing embodiment, the working principle of the bidirectional power converter including the full-bridge circuit is described. The following describes a working principle of the bidirectional power converter including the half-bridge circuit with reference to accompanying drawings.

In the energy storage system provided in this embodiment, the corresponding i^{th} bidirectional power converter of the i^{th} battery includes the half-bridge circuit. The half-bridge circuit includes a fifth switching transistor, a sixth switching transistor, and a capacitor. For example, the energy storage system includes N batteries connected in series, and correspondingly includes N half-bridge circuits and N windings. N is an integer greater than or equal to 2. N is not limited in this embodiment. The following describes a working principle of the energy storage system in detail by using an example in which N is equal to 3. In this embodiment, the target battery is a battery with a highest voltage in the three batteries.

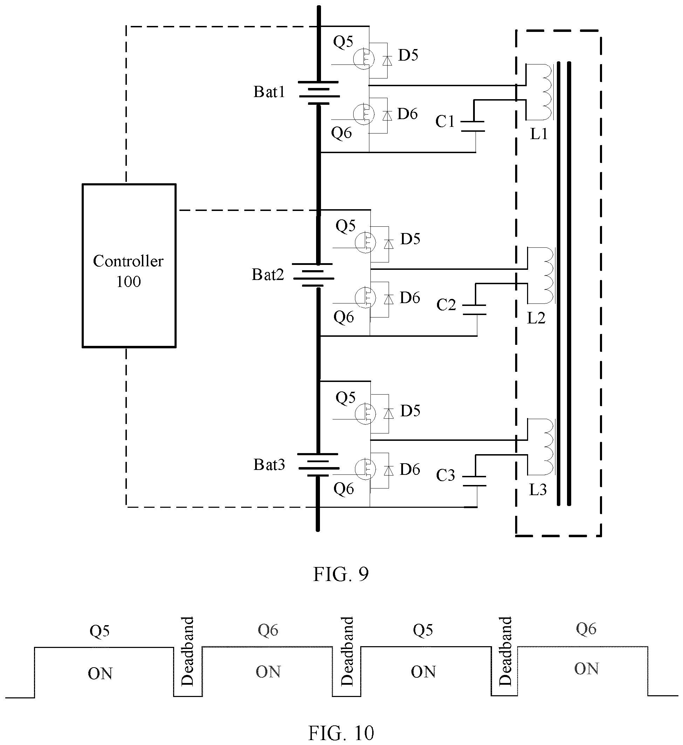

FIG. 9 is a schematic diagram of an energy storage system including the half-bridge circuit according to an embodiment of this application.

In the corresponding half-bridge circuit of the first battery Bat1, a bridge arm includes a fifth switching transistor Q5 and a sixth switching transistor Q6 that are connected in series. A first terminal of the fifth switching transistor Q5 is connected to the positive terminal of the first battery Bat1. A second terminal of the fifth switching transistor Q5 is connected to a first terminal of the sixth switching transistor Q6. A second terminal of the sixth switching transistor is connected to the negative terminal of the first battery Bat1. The first terminal of the first winding L1 is connected to a midpoint of the bridge arm. The second terminal of the first winding is connected to a first terminal of a capacitor C1. A second terminal of the capacitor C1 is connected to the negative terminal of the first battery Bat1. The fifth switching transistor Q5 and the sixth switching transistor Q6 each include an anti-parallel diode. The anti-parallel diodes respectively correspond to a diode D5 and a diode D6.

In FIG. 9, an example in which the half-bridge circuits of the first battery, the second battery, and the third battery have a same structure is used for description. Components in the half-bridge circuits also have same reference numerals. A connection manner of the corresponding half-bridge circuit and winding of the second battery Bat2 is the same as that of the first battery Bat1. A connection manner of the corresponding half-bridge circuit and winding of the third battery Bat3 is also the same as that of the first battery Bat1. Details are not described herein again.

The controller may send the drive signal to the bidirectional power converter to control the on/off state of the switching transistor, thereby implementing battery charging and discharging. The following describes the working principle of the controller with reference to FIG. 10.

FIG. 10 is a schematic diagram of another drive signal according to an embodiment of this application.

It is assumed that the battery with the highest current voltage is the first battery Bat1, the controller 100 controls the fifth switching transistor Q5 in the corresponding half-bridge circuit of the first battery Bat1 to be turned on, and controls the sixth switching transistor Q6 to be turned off. A discharge path of the first battery Bat1 is as follows: The current flows through the fifth switching transistor Q5, the first winding L1, and the capacitor C1 from the positive terminal of the first battery Bat1, and returns to the negative terminal of the first battery Bat1, to implement discharging. A voltage of the direct-current blocking capacitor C1 is half of a voltage U1 of the first battery Bat1, that is, 1/2U1. When Q5 is turned on and Q6 is turned off, a voltage between the two terminals of L1 is half of the voltage U1 of the first battery Bat1, that is, 1/2U1. L1 transfers the energy to L2 and L3. In this case, the voltage of L2 and the voltage of L3 are also 1/2U1. When Q5 is turned off and Q6 is turned on, a voltage between two terminals of L1 is -1/2U1, that is, the voltage of the capacitor C1. The transformer implements excitation reset.

In addition, the controller 100 controls the corresponding fifth switching transistor Q5 and sixth switching transistor Q6 of the second battery Bat2 to be both turned off. In this case, a sum of the voltage of a capacitor C2 and the voltage of the winding L2 is greater than the voltage of the second battery Bat2, and therefore the second battery Bat2 is charged. A current path is that: A current flows through the second winding L2, the diode D5, and the second battery Bat2, and returns to the capacitor C2, to transfer the energy to the second battery Bat2, so as to charge the second battery Bat2. For example, a voltage of the second battery Bat2 is represented by U2. When a voltage between two terminals of L2 is 1/2U1, a series voltage (1/2U1+1/2U2) of the L2 and the capacitor C2 is greater than U2, the anti-parallel diode of Q5 bears a positive voltage to be turned on, and L2 charges the second battery Bat2 by using the anti-parallel diode of Q5 in the corresponding half-bridge circuit of the second battery Bat2. When a voltage between the two terminals of the winding L2 is -1/2U1, a reverse series voltage 1/2U1 of L2 and the capacitor C2 is greater than -1/2U2, the anti-parallel diode of Q6 in the corresponding half-bridge circuit of the second battery Bat2 bears the positive voltage to be turned on, and L2 completes excitation reset through diode freewheeling.

A principle of charging the third battery by the controller 100 is the same as that of charging the second battery, and details are not described herein again.

After a period of dead time, the controller 100 controls the corresponding fifth switching transistor Q5 of the first battery Bat1 to be turned off, and controls the corresponding sixth switching transistor Q6 to be turned on. In this case, a current of the capacitor C1 flows through the first winding L1, the diode D5, and the first battery Bat1 from the first terminal of the capacitor C1, and returns to the second terminal of the capacitor C1, to transfer the energy stored in the capacitor C1 to the magnetic core, so as to discharge the first battery Bat1. It should be noted that, within a period of dead time, the controller 100 controls the fifth switching transistor Q5 and the sixth switching transistor Q6 to be both turned off, to prevent the first battery Bat1 from being short-circuited.

In this case, charging principles of the second battery Bat2 and the third battery Bat3 are not described herein again.

As the battery is charged and discharged, the battery with the highest voltage may change after a period of time, and the controller needs to select a new battery with a highest voltage to be discharged, and controls another battery to be charged. In a possible case, after a preset period of time, the battery with the highest voltage is the second battery. In this case, the controller controls the corresponding bidirectional power converter of the second battery to perform power conversion, to transfer the energy to the magnetic core, and controls the corresponding bidirectional power converters of the first battery and the third battery to stop power conversion, to work in the freewheeling state by using the anti-parallel diode, so as to increase the voltages of the first battery and the third battery through charging. For a specific implementation, refer to the foregoing embodiment, and details are not described herein again.

In the foregoing embodiment, when controlling the battery to be charged, the controller needs to control the corresponding fifth switching transistor and sixth switching transistor of the battery to be both turned off, to work in the freewheeling state by using the anti-parallel diode, so as to charge the battery.

In another possible implementation, the controller controls the corresponding fifth switching transistor of the battery to be turned on and the corresponding sixth switching transistor to be turned off, and the capacitor transfers the energy to the battery by using the fifth switching transistor, to charge the battery. With reference to FIG. 9, the following provides descriptions by using an example in which the controller controls the first battery to be discharged and controls the second battery and the third battery to be charged.

The principle of controlling discharging of the first battery Bat1 by the controller 100 has been described in detail in the foregoing embodiment, and details are not described herein again.

When charging the second battery Bat2, the controller 100 controls the fifth switching transistor Q5 of the second battery Bat2 to be turned on and the sixth switching transistor Q6 of the second battery Bat2 to be turned off, so that a current of the capacitor C2 flows through the second winding L2, the fifth switching transistor Q5, and the second battery Bat2 from the first terminal of the capacitor C2, and finally returns to the second terminal of the capacitor C2, to transfer the energy of the capacitor C2 to the second battery Bat2, so as to charge the second battery Bat2.

Similarly, the principle of charging the third battery Bat3 by the controller 100 is the same as that of charging the second battery Bat2, and details are not described herein again.

When the controller controls the fifth switching transistor and the sixth switching transistor to be both turned off, and charges the battery by using the diode, a voltage drop caused by the turned-on diode is large, resulting in a large energy loss of the battery. When the controller controls the fifth switching transistor to be turned on and the sixth switching transistor to be turned off to charge the battery, a voltage drop caused by the turned-on switching transistor is less than the voltage drop caused by the turned-on diode, so that the energy loss of the battery is reduced.

In the energy storage system provided in this embodiment, each bidirectional power converter includes one half-bridge circuit. The switching transistors in the half-bridge circuit are controlled to be alternately turned on to discharge the battery. Compared with the full-bridge circuit, the half-bridge circuit requires fewer switching transistors, costs are lower, and the control logic of the controller is simpler. However, compared with the full-bridge circuit, the half-bridge circuit has lower energy transfer efficiency, which is half of that of the full-bridge circuit.

In the energy storage system provided in this embodiment, each battery corresponds to one bidirectional power converter. When one battery is short-circuited because the switching transistor in the half-bridge circuit performs a misoperation or is faulty, only the battery is short-circuited, and normal working of another battery is not affected. For example, the fifth switching transistor and the sixth switching transistor in the corresponding bidirectional power converter of the first battery are both turned on, so that the first battery is short-circuited, and working of another battery is not affected. In addition, because each battery corresponds to one bidirectional power converter, a voltage borne by the bidirectional power converter is a voltage of one battery. A switching transistor of the bidirectional power converter bears a low voltage. This facilitates selection of the switching transistor in the bidirectional power converter. Only the switching transistor with a low withstand voltage needs to be selected, so that costs are reduced.

In the energy storage system provided in this embodiment of this application, if any two batteries in the batteries connected in series have a same specification, that is, have a same rated voltage value, a turn ratio of any two windings is 1:1. If a ratio of rated voltage values of two batteries is a:b, a turn ratio of the windings corresponding to the two batteries is also a:b.

A specific implementation of the controller is not limited in this embodiment of this application. For example, the controller may be any one of the following: a complex programmable logic device (Complex Programmable Logic Device, CPLD), a field programmable gate array (Field Programmable Gate Array, FPGA), or a digital signal processor (Digital Signal Processor, DSP).

Each battery in the energy storage system provided in the foregoing embodiment may include a plurality of cells. Because a voltage of one cell is limited, for better control, one battery may include a plurality of cells connected in series. The voltage equalization solution described above is applicable to voltage equalization between the batteries. The following describes a voltage equalization solution between the plurality of cells inside one battery.

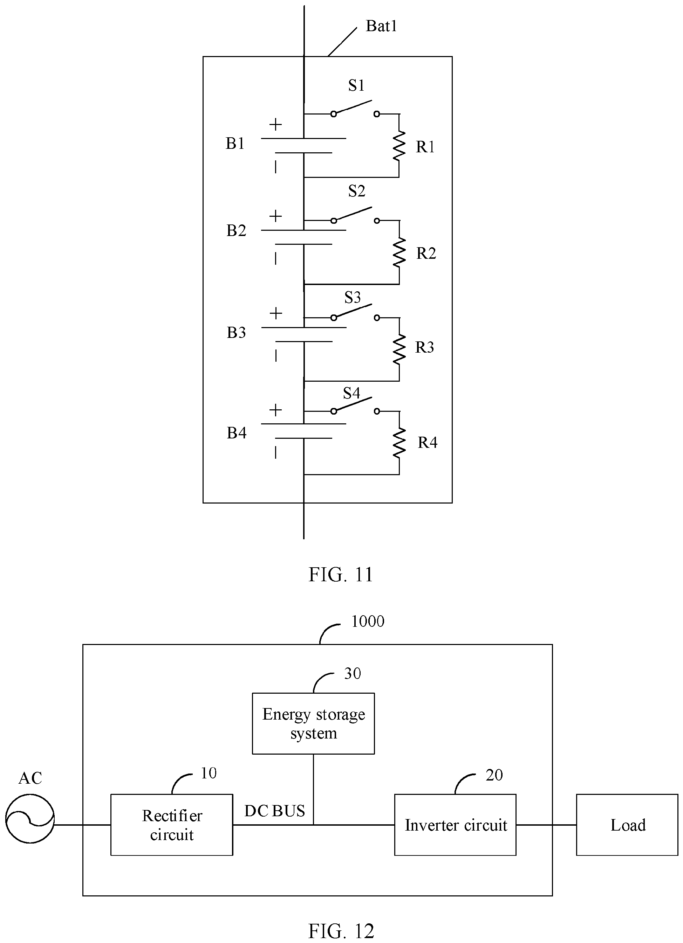

FIG. 11 is a structural diagram of an interior of the battery according to an embodiment of this application.

Each of the N batteries includes a plurality of cells.

Two ends of each cell in the plurality of cells are connected in parallel to a balanced branch. The balanced branch includes a switch and a resistor that are connected in series.

The controller is further configured to: when the voltage of the cell is greater than a preset voltage, control the switch in the balanced branch to be closed, so that the resistor consumes energy of the cell.

In FIG. 11, an example in which one battery includes four cells connected in series is used for description. In an actual product, more cells may be connected in series. Specifically, a quantity of cells may be selected based on a battery voltage required in an actual application scenario. For example, 20 cells may be selected to be connected in series to form one battery. The following uses voltage equalization between cells inside the first battery Bat1 as an example for description.

A positive electrode of a first cell B1 is used as the positive terminal of the first battery Bat1. A negative electrode of the first cell B1 is connected to a positive electrode of a second cell B2. A negative electrode of the second cell B2 is connected to a positive electrode of a third cell B3. A negative electrode of the third cell B3 is connected to a positive electrode of a fourth cell B4. A negative electrode of the fourth cell B4 is used as the negative terminal of the first battery Bat1.

In addition, to reduce a voltage of the cell, the resistor is used to consume electric energy, that is, when the switch connected in series to the resistor is closed, two terminals of the resistor are connected to two ends of the cell, the cell discharges to the resistor, and the voltage of the cell is reduced, to implement voltage equalization of the cell. For example, the positive electrode of the first cell B1 is connected to the negative electrode of the first cell B1 by using a first switch S1 and a first resistor R1 that are connected in series. The positive electrode of the second cell B2 is connected to the negative electrode of the second cell B2 by using a second switch S2 and a second resistor R2 that are connected in series. The positive electrode of the third cell B3 is connected to the negative electrode of the third cell B3 by using a third switch S3 and a third resistor R3 that are connected in series. The positive electrode of the fourth cell B4 is connected to the negative electrode of the fourth cell B4 by using a fourth switch S4 and a fourth resistor R4 that are connected in series. The battery provided in this embodiment of this application may be a pack, that is, a battery module, including a plurality of cells. A voltage of the pack may be set based on an actual selection. For example, a voltage of the pack may be greater than 40 V, for example, 48 V or 60 V.

### UPS Embodiment

According to the energy storage system provided in the foregoing embodiment, this embodiment of this application further provides a UPS. The following provides a detailed description with reference to the accompanying drawings.

FIG. 12 is a schematic diagram of a UPS according to an embodiment of this application.

The UPS 1000 provided in this embodiment may be used in any scenario of uninterruptible power supply, which is not specifically limited in this embodiment. An uninterruptible power system 1000 provided in this embodiment includes: a rectifier circuit, an inverter circuit, and any energy storage system 30 described in the foregoing embodiment.

An input terminal of the rectifier circuit is configured to be connected to an alternating current power supply. An output terminal of the rectifier circuit is connected to a direct current bus.

An input terminal of the inverter circuit is connected to the direct current bus. N batteries are connected in series to the direct current bus. An output terminal of the inverter circuit is configured to provide an alternating current to a load.

Because the UPS can implement uninterruptible power supply, the UPS needs to include a battery string. The battery string generally includes a plurality of batteries connected in series. This embodiment is described by using the N batteries connected in series as an example. N is an integer greater than or equal to 2. Because the energy storage system can implement voltage equalization of the N batteries connected in series, and an equalization speed is high, the UPS during working can fully discharge and charge each battery, thereby improving electric energy utilization. In addition, when voltages are equalized between the batteries, energy is transferred by using a winding and a magnetic core. Therefore, signal isolation can be implemented without mutual interference. In addition, because each bidirectional power converter corresponds to one battery, a voltage borne by each bidirectional power converter is a voltage of the corresponding battery, and the voltage is low. Therefore, a switching transistor in the bidirectional power converter also bears a low voltage. A switching transistor with a low withstand voltage may be selected, which facilitates selection of the switching transistor. A lower withstand voltage of the switching transistor leads to a lower price. Therefore, this helps reduce costs of the entire energy storage system.

In addition, each battery corresponds to one bidirectional power converter. The full-bridge circuit is used as an example. When one battery is short-circuited because the switching transistor in the full-bridge circuit performs a misoperation or is faulty, only the battery is short-circuited, and normal working of another battery is not affected. For example, a first switching transistor and a fourth switching transistor in a corresponding bidirectional power converter of a first battery are both closed, so that the first battery is short-circuited, and working of another battery is not affected.

### Method Embodiment

According to the energy storage system and the UPS provided in the foregoing embodiments, this embodiment of this application further provides a battery equalization method. The following provides a detailed description with reference to the accompanying drawings.

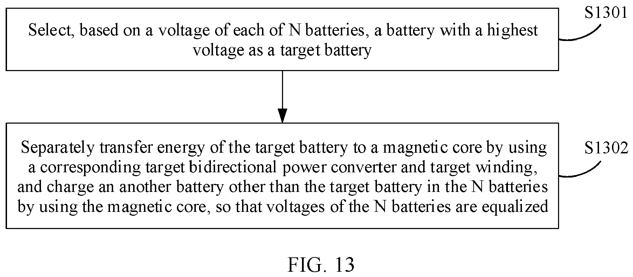

FIG. 13 is a flowchart of a battery equalization method according to an embodiment of this application.

The battery equalization method provided in this embodiment is applied to N batteries connected in series. The N batteries correspond to N bidirectional power converters and N windings. Two terminals of an i^{th} battery in the N batteries are connected to a first port of an i^{th} bidirectional power converter in the N bidirectional power converters. A second port of the i^{th} bidirectional power converter is connected to an i^{th} winding in the N windings, where i is any integer of 1 to N. The N windings share a magnetic core. During specific implementation, energy of a target battery in the N batteries is separately transferred to the magnetic core by using a target bidirectional power converter and a target winding, and another battery other than the target battery in the N batteries is charged by using the magnetic core, so that voltages of the N batteries are equalized. A voltage of the target battery is greater than those of some or all batteries other than the target battery in the N batteries. The target battery may be one or more batteries.

In the method, the energy of the target battery in the N batteries is separately transferred to the magnetic core by using the target bidirectional power converter and the target winding. In a possible implementation, the energy of the target battery with a highest voltage in the N batteries is transferred to the magnetic core by using the corresponding target bidirectional power converter and the target winding.

The method specifically includes the following steps:
S1301: Select, based on the voltage of each of the N batteries, a battery with a highest voltage as the target battery.
S1302: Separately transfer energy of the target battery to the magnetic core by using the corresponding target bidirectional power converter and the target winding, and charge the another battery other than the target battery in the N batteries by using the magnetic core, so that the voltages of the N batteries are equalized.

According to the battery equalization method, only the battery with the highest voltage is controlled to transfer energy to another battery by using the bidirectional power converter at a same time, that is, the battery with the highest voltage is discharged, and the another battery is charged. Only one battery is discharged, and another battery is charged at a same time. In this way, the voltage of the battery with the highest voltage can be quickly pulled down, so that the voltages of the N batteries connected in series can be quickly equalized.

In a possible implementation, separately transferring the energy of the battery with the highest voltage in the N batteries to the magnetic core by using a corresponding bidirectional power converter and winding, and charging the another battery in the N batteries by using the magnetic core specifically include:
selecting the battery with the highest voltage based on the voltages of the N batteries;
controlling the corresponding bidirectional power converter of the battery with the highest voltage to perform power conversion, to transfer the energy of the battery with the highest voltage to the magnetic core; and
controlling a corresponding bidirectional power converter of the another battery in the N batteries to stop power conversion to work in a freewheeling state, to charge the another battery.

In a possible implementation, separately transferring the energy of the battery with the highest voltage in the N batteries to the magnetic core by using a corresponding bidirectional power converter and winding, and charging the another battery in the N batteries by using the magnetic core specifically include:
controlling the corresponding bidirectional power converter of the battery with the highest voltage in the N batteries to perform power conversion, and controlling a corresponding bidirectional power converter of the another battery in the N batteries to stop power conversion; and
after a preset period of time, selecting a new corresponding bidirectional power converter of the battery with the highest voltage in the N batteries to perform power conversion, and controlling a corresponding bidirectional power converter of another battery in the N batteries to stop power conversion, and so on.

It should be understood that in this application, "at least one (item)" refers to one or more and "a plurality of" refers to two or more. Therefore, any simple amendment, equivalent variation, and modification made on the above embodiments according to the technical essence of this application without departing from the content of the technical solutions of this application shall fall within the protection scope of the technical solutions of this application.

## Claims

1. An energy storage system, comprising: a controller, N batteries, N bidirectional power converters, and N windings, wherein N is an integer greater than or equal to 2;
the N batteries are connected in series, and the N windings share a magnetic core;
two terminals of an i^{th} battery in the N batteries are connected to a first port of an i^{th} bidirectional power converter in the N bidirectional power converters, a second port of the i^{th} bidirectional power converter is connected to an i^{th} winding in the N windings, and i is any integer of 1 to N; and
the controller is configured to separately transfer energy of a target battery to the magnetic core by using a target bidirectional power converter and a target winding, and charge one or more other batteries other than the target battery in the N batteries by using the magnetic core, so that voltages of the N batteries are equalized, wherein the voltage of the target battery is greater than those of some or all batteries other than the target battery in the N batteries.

2. The energy storage system according to claim 1, wherein the target battery is a battery with a highest voltage in the N batteries; and the controller is specifically configured to transfer the energy of the target battery to the magnetic core by using the corresponding target bidirectional power converter and the target winding, and charge other N-1 batteries in the N batteries by using the magnetic core, so that the voltages of the N batteries are equalized.

3. The energy storage system according to claim 2, wherein the controller is specifically configured to select the target battery based on the voltages of the N batteries, control the corresponding target bidirectional power converter of the target battery to perform power conversion to transfer the energy of the target battery to the magnetic core, and control a corresponding bidirectional power converter of the one or more other batteries other than the target battery in the N batteries to work in a freewheeling state.

4. The energy storage system according to claim 3, wherein the controller is specifically configured to periodically select the target battery from the N batteries, control the corresponding target bidirectional power converter of the target battery to perform power conversion, and control the corresponding bidirectional power converter of the one or more other batteries other than the target battery in the N batteries to work in the freewheeling state.

5. The energy storage system according to any one of claims 1 to 4, wherein the bidirectional power converter comprises a full-bridge circuit or a half-bridge circuit.

6. The energy storage system according to claim 5, wherein the i^{th} bidirectional power converter comprises a full-bridge circuit;
the full-bridge circuit comprises a first bridge arm and a second bridge arm that are connected in parallel, wherein a midpoint of the first bridge arm is connected to a first terminal of the target winding, and a midpoint of the second bridge arm is connected to a second terminal of the target winding;
the first bridge arm comprises a first switching transistor and a fourth switching transistor that are connected in series, and the second bridge arm comprises a second switching transistor and a third switching transistor that are connected in series; a first terminal of the first switching transistor and a first terminal of the second switching transistor are both connected to a positive terminal of the i^{th} battery, and a second terminal of the first switching transistor is connected to a first terminal of the fourth switching transistor; a second terminal of the fourth switching transistor and a second terminal of the third switching transistor are both connected to a negative terminal of the i^{th} battery, and a second terminal of the second switching transistor is connected to a first terminal of the third switching transistor; and the first switching transistor, the second switching transistor, the third switching transistor, and the fourth switching transistor each comprise an anti-parallel diode; and
the controller is specifically configured to control the first switching transistor and the second switching transistor to be alternately turned on, the third switching transistor and the first switching transistor to synchronously work, and the fourth switching transistor and the second switching transistor to synchronously work, so that the target bidirectional power converter performs power conversion; and further specifically configured to control the first switching transistor, the second switching transistor, the third switching transistor, and the fourth switching transistor to be all turned off, so that one or more bidirectional power converters other than the target bidirectional power converter in the N bidirectional power converters works in the freewheeling state.

7. The energy storage system according to claim 5, wherein the i^{th} bidirectional power converter comprises a full-bridge circuit;
the full-bridge circuit comprises a first bridge arm and a second bridge arm that are connected in parallel, wherein a midpoint of the first bridge arm is connected to a first terminal of the target winding, and a midpoint of the second bridge arm is connected to a second terminal of the target winding;
the first bridge arm comprises a first switching transistor and a fourth switching transistor that are connected in series, and the second bridge arm comprises a second switching transistor and a third switching transistor that are connected in series; a first terminal of the first switching transistor and a first terminal of the second switching transistor are both connected to a positive terminal of the i^{th} battery, and a second terminal of the first switching transistor is connected to a first terminal of the fourth switching transistor; a second terminal of the fourth switching transistor and a second terminal of the third switching transistor are both connected to a negative terminal of the i^{th} battery, and a second terminal of the second switching transistor is connected to the first terminal of the third switching transistor; and
the controller is specifically configured to control the first switching transistor and the second switching transistor to be alternately turned on, the third switching transistor and the first switching transistor to synchronously work, and the fourth switching transistor and the second switching transistor to synchronously work, so that the target bidirectional power converter performs power conversion; and further specifically configured to control the first switching transistor and the third switching transistor to be both turned on and the second switching transistor and the fourth switching transistor to be both turned off, so that one or more bidirectional power converters other than the target bidirectional power converter in the N bidirectional power converters works in the freewheeling state.

8. The energy storage system according to claim 5, wherein the i^{th} bidirectional power converter comprises a half-bridge circuit;
the half-bridge circuit comprises a fifth switching transistor, a sixth switching transistor, and a capacitor;
a first terminal of the fifth switching transistor is connected to a positive terminal of the i^{th} battery, a second terminal of the fifth switching transistor is connected to a first terminal of the sixth switching transistor, and a second terminal of the sixth switching transistor is connected to a negative terminal of the i^{th} battery; the fifth switching transistor and the sixth switching transistor each comprise an anti-parallel diode;
the second terminal of the fifth switching transistor is connected to a first terminal of the target winding, a first terminal of the capacitor is connected to a second terminal of the target winding, and a second terminal of the capacitor is connected to the second terminal of the sixth switching transistor; and
the controller is specifically configured to control the fifth switching transistor and the sixth switching transistor to be alternately turned on, so that the target bidirectional power converter performs power conversion; and further configured to control the fifth switching transistor and the sixth switching transistor to be both turned off, so that one or more bidirectional power converters other than the target bidirectional power converter in the N bidirectional power converters works in the freewheeling state.

9. The energy storage system according to claim 5, wherein the i^{th} bidirectional power converter comprises a half-bridge circuit;
the half-bridge circuit comprises a fifth switching transistor, a sixth switching transistor, and a capacitor;
a first terminal of the fifth switching transistor is connected to a positive terminal of the i^{th} battery, a second terminal of the fifth switching transistor is connected to a first terminal of the sixth switching transistor, and a second terminal of the sixth switching transistor is connected to a negative terminal of the i^{th} battery; the fifth switching transistor comprises an anti-parallel diode;
the second terminal of the fifth switching transistor is connected to a first terminal of the target winding, a first terminal of the capacitor is connected to a second terminal of the target winding, and a second terminal of the capacitor is connected to the second terminal of the sixth switching transistor; and
the controller is specifically configured to control the fifth switching transistor and the sixth switching transistor to be alternately turned on, so that the target bidirectional power converter performs power conversion; and further configured to control the fifth switching transistor to be turned on and the sixth switching transistor to be turned off, so that one or more bidirectional power converters other than the target bidirectional power converter in the N bidirectional power converters works in the freewheeling state.

10. The energy storage system according to any one of claims 1 to 9, wherein if rated voltage values of any two batteries in the N batteries are the same, a turn ratio of any two windings in the N windings is 1:1.

11. The energy storage system according to any one of claims 1 to 9, wherein if a ratio of rated voltage values of two batteries in the N batteries is a:b, a turn ratio of windings respectively corresponding to the two batteries is a:b.

12. The energy storage system according to any one of claims 1 to 11, further comprising a voltage sensor, wherein
the voltage sensor is configured to detect the voltage of each of the N batteries and send the detected voltage of each battery to the controller.

13. The energy storage system according to any one of claims 1 to 12, wherein each of the N batteries comprises a plurality of cells;
two ends of each cell in the plurality of cells are connected in parallel to a balanced branch, wherein the balanced branch comprises a switch and a resistor that are connected in series; and
the controller is further configured to: when a voltage of the cell is greater than a preset voltage, control the switch in the balanced branch to be turned on, so that the resistor consumes energy of the cell.

14. An uninterruptible power system, comprising: a rectifier circuit, an inverter circuit, and the energy storage system according to any one of claims 1 to 13, wherein
an input terminal of the rectifier circuit is configured to be connected to an alternating current power supply, and an output terminal of the rectifier circuit is connected to a direct current bus; and
an input terminal of the inverter circuit is connected to the direct current bus, the N batteries are connected in series to the direct current bus, and an output terminal of the inverter circuit is configured to provide an alternating current to a load.

15. A battery equalization method, applied to N batteries connected in series, wherein the N batteries correspond to N bidirectional power converters and N windings, two terminals of an i^{th} battery in the N batteries are connected to a first port of an i^{th} bidirectional power converter in the N bidirectional power converters, a second port of the i^{th} bidirectional power converter is connected to an i^{th} winding in the N windings, i is any integer of 1 to N, and the N windings share a magnetic core; and the method comprises:
separately transferring energy of a target battery to the magnetic core by using a target bidirectional power converter and a target winding, and charging one or more other batteries other than the target battery in the N batteries by using the magnetic core, so that voltages of the N batteries are equalized, wherein the voltage of the target battery is greater than those of some or all batteries other than the target battery in the N batteries.
